# EUROPEAN PATENT SPECIFICATION

(11) **EP 0 809 150 B1**
(45) Date of publication and mention of the grant of the patent: **19.07.2000**
(21) Application number: 97106705.3
(22) Date of filing: 23.04.1997
(51) Int. Cl.: G03F 7/004

(54) **Photosensitive aqueous developable thick film composition employing vinylpyrrolidone polymer**
Lichtempfindliche, wässerig entwickelbare Dickschichtzusammensetzung unter Verwendung von Polyvinylpyrrolidon
Composition pour la formation de films épais, photosensible, développable en milieu aqueux et contenant du polyvinylpyrrolidone

(30) Priority: 21.05.1996 US 646797
(43) Date of publication of application: 26.11.1997
(73) Proprietor: E.I. DU PONT DE NEMOURS AND COMPANY, Wilmington Delaware 19898 (US)
(72) Inventor: Suess, Terry R., Raleigh, North Carolina 27614-9024 (US)
(74) Representative: Kuhnen & Wacker

(56) References cited:
- EP-A- 0 373 662
- EP-A- 0 571 672
- FR-A- 2 154 711
- US-A- 4 912 019
- US-A- 5 032 478
- US-A- 5 032 490
- US-A- 5 049 480

## Description

### BACKGROUND OF THE INVENTION

The present invention is directed to an improved conductive or dielectric photosensitive thick film composition having thixotropic properties which aid in one or more of the properties of reduced settling, improved leveling and increased printing speed.

Multilayer thick film circuits have been used for many years to increase circuit functionality per unit of area. Moreover, continuing advances in circuit technology have placed new demands on electronically conductive and dielectric materials for this use.

These compositions are comprised of finely divided particles, electrically conductive metal or dielectric solids, and inorganic binders dispersed in an inert medium. These thick film materials are usually applied by screen printing in the pattern desired for the conductor.

Thick film materials are very important and will continue to be so. However, when applying these thick film materials in patterns by screen printing, it is difficult to obtain fine line and space resolution. It is essential that all the screen printing variables such as screen quality, squeegee hardness, print speed, dispersion properties, etc., be most carefully controlled and constantly monitored to obtain good product yields.

The process in employing photosensitive thick film materials is (1) to apply a layer of the material to a substrate by means of dispersion in a photosensitive medium, (2) to expose the layer imagewise to actinic radiation, (3) to develop the pattern to remove unexposed portions of the layer, and (4) to fire the remaining exposed portions of the pattern to remove all remaining organic materials and to sinter the inorganic materials.

U.S. Patent 5,032,478, U.S. Patent 5,049,480, U.S. Patent 5,032,490, and U.S. Patent 4,912,019 respectively teach photosensitive aqueous developable compositions containing gold, silver, copper, and ceramic.

The present invention is considered to be an improvement of the compositions of these patents by introduction of a component which aids in obtaining uniformity and which introduces thixotropic behavior to the unfired composition.

### SUMMARY OF THE INVENTION

The present invention is directed to an aqueous developable electrically conductive or insulating composition which is fireable in an oxidizing or substantially nonoxidizing atmosphere comprising an admixture of:
(a) finely divided particles of electrically conducting or dielectric solids having a surface area-to-weight ratio of no greater than 20 m²/g and at least 80 percent by weight of the articles having a size of 0.5-10 µm and
(b) finely divided particles of an inorganic binder having a glass transition temperature in the range of from 325° to 875°C, a surface area-to-weight ratio of no greater than 10 m²/g and at least 90 wt. % of the particles having a size of 0.4-10 µm, the weight ratio of (b) to (a) being in a range from 0.0001 to 0.25, dispersed in an organic vehicle comprising
(c) an organic polymeric binder of a copolymer or interpolymer comprising (1) a non-acidic comonomer of a C₁-C₁₀ alkyl acrylate or C₁-C₁₀ alkyl methacrylate and (2) an ethylenically unsaturated carboxylic acid, with the proviso that all acidic comonomers comprise at least 15 weight percent of the polymer, wherein the organic polymeric binder has a molecular weight no greater than 50,000,
(d) a photoinitiation system,
(e) photohardenable monomer,
(f) an organic medium, and wherein the composition upon imagewise exposure to actinic radiation is developable in an aqueous solution containing 0.8 percent by weight sodium carbonate, wherein the improvement comprises the composition containing
(g) a homopolymer or copolymer of vinylpyrrolidone.

When the composition is electrically conductive preferred finely divided particles of (a) include gold, silver, platinum, palladium, ruthenium dioxide, pyrochlores, copper, or mixtures thereof. When the composition is an insulator, i.e., a dielectric, preferred finely divided particles of (a) including ceramic solids.

### DETAILED DESCRIPTION OF THE INVENTION

The present composition is photosensitive and is conventionally imagewise exposed to actinic radiation while on a substrate. Thereafter, an aqueous alkaline developer removes areas of the composition which have not been exposed to actinic radiation while not removing the exposed composition. Thereafter, the composition is fired in an oxidizing or a substantially non-oxidizing atmosphere. The components of the photosensitive composition are known except for a copolymer or polymer of vinylpyrrolidone in the environment of such composition.

### A. Solids of Electrical Conductors or Insulators

When the composition is electrically conductive typically a method of gold, silver, platinum copper, pyrochlore or mixtures thereof are used. Virtually any shape metal powder, including spherical particles and flake (rods, cones, plates) may be used in practicing the invention. It is preferred that the particles be spherical. It has been found that the dispersion of the invention conventionally should not contain significant amounts of solids having a particles size of less than 0.2 µm. When particles of this small size are present it is difficult to adequately obtain complete burnout of the organic medium when the films or layers thereof are fired to remove the organic medium and to effect sintering of the inorganic binder and the metal solids. In addition, none of the metal solids should exceed 20 µm. When the dispersions are used to make thick film pastes, which are usually applied by screen printing, the maximum particle size must not exceed the thickness of the screen. It is preferred that at least 80 percent by weight of the metal solids fall within the 0.5-10 µm range.

In addition, it is preferred that the surface area/weight ratio of the metal particles not exceed 20 m²/g, preferably 10 m²/g and more preferably 5 m²/g. When metal particles having a surface area/weight ratio greater than 20 m²/g are used, the sintering characteristics of the accompanying inorganic binder are adversely affected. It is difficult to obtain adequate burnout and blisters may appear.

When the composition is electrically insulating typically a high melting inorganic solid material is used as a dielectric. Dispersions of dielectric solids such as alumina, titanates, zirconates and stannates are typically employed. It is also applicable to precursors of such materials, i.e., solid materials which upon firing are converted to dielectric solids, and to mixtures of any of these.

Among the many dielectric solids which are suitable include: BaTiO₃, CaTiO₃, SrTiO₃, PbTiO₃, CaZrO₃, BaZrO₃, CaSnO₃, BaSnO₃, and Al₂O₃. As will be apparent to those skilled in the ceramic arts, the exact chemical composition of the ceramic solids to be used in the composition of the invention is not ordinarily critical in a rheological sense. It is also preferred that the ceramic solids not have swelling characteristics in the organic dispersion since the rheological properties of the dispersion may be substantially changed thereby.

The same requirements concerning particle and surface requirements of conductive particles apply to the electrically insulating particles.

### B. Inorganic Binder

An inorganic binder and generally a glass frit used in the present invention aids in sintering the conductive or insulating particles and may be of any well known composition which has a melting temperature below that of the conductive or insulating particles. It is preferred that the glass transition temperature (T_{g}) of the inorganic binder be 325°-875°C and still more preferably 375°-800°C. If the melting takes place below 325°C, organic material will likely be encapsulated and blisters will tend to form in the composition as the organics decompose. On the other hand, a glass transition temperature above 875°C will tend to produce a composition with poor adhesion when sintering temperatures below 900°C are used.

The glass frit most preferably used are the borosilicate frits, such as lead borosilicate frit, bismuth, cadmium, barium, calcium or other alkaline earth borosilicate frits. The preparation of such glass frits is well known and consists, for example, in melting together the constituents of the glass in the form of the oxides of the constituents and pouring such molten composition into water to form the frit. The batch ingredients may, of course, be any compound that will yield the desired oxides under the usual conditions of frit production. For example, boric oxide will be obtained from boric acid, silicon dioxide will be produced from flint, barium oxide will be produced from barium carbonate, etc.

The frit is passed through a fine mesh screen to remove large particles since the solid composition should be agglomerate free. The inorganic binder should have a surface to weight ratio of no more than 10 m²/g. Preferably at least 90 percent by weight of the particles have a particle size of 0.4-10 µm.

The inorganic binder is preferably 0.01 to 25 percent by weight of the weight of the conductive or insulating particles. At higher levels of inorganic binder, the bondability to the substrate is reduced.

### C. Organic Polymeric Binder

The binder polymer allows for aqueous processability and at the same time affords high resolution. It has been found that these requirements are met by selecting a binder which is a copolymer or interpolymer comprising (1) a nonacidic comonomer comprising a C₁-C₁₀ alkyl acrylate, C₁-C₁₀ alkyl methacrylate, and (2) an acid comonomer comprising an ethylenically unsaturated carboxylic acid containing moiety which is at least 15% by weight of the total polymer weight.

The presence of the acidic comonomer component of the composition is critical to this technology. The acid functionality yields developability in aqueous base, such as a 0.8% solution of sodium carbonate. When the acid comonomer is present in concentrations of acid below 15%, the compositions do not wash out in aqueous base. When the acid comonomer is present in concentration above 30%, the compositions generally are unstable under humid conditions and also partially develop in the imaged areas. Suitable acidic comonomers include ethylenically unsaturated monocarboxylic acids such as acrylic, methacrylic, and crotonic acids and ethylenically unsaturated dicarboxylic acids such as fumaric, itaconic, citraconic, vinyl succinic and maleic acids as well as their half esters and, where appropriate, their anhydrides and mixtures thereof. Because they are cleaner burning in low-oxygen atmospheres, methacrylic polymers are preferred over acrylic polymers. With alkyl acrylate or alkyl methacrylate, it is preferred that this comonomer constitute at least 50 and preferably 70-75 wt % of the polymer.

Although not preferred, the nonacidic portion of the polymer binder can contain up to about 50 wt % of other nonacidic comonomers as a substitute for the alkyl acrylate, alkyl methacrylate, styrene or substituted styrene portion of the polymer. Examples include acrylonitrile, vinyl acetate, acrylamide, and the like so long as the previously discussed compositional criteria are met as well as the physical criteria mentioned below. However, it is preferred to use not more than about 25 wt % of the total binder polymer of such monomers because they are more difficult to burn out cleanly.

It will be recognized that a single copolymer or a combination of copolymers, each of which satisfies the above criteria, may be used as the binder.

In addition to the above-described copolymers, it is possible to add small amounts of other polymeric binders. Examples of these include polyolefins such as polyethylene, polypropylene, polybutylene, polyisobutylene, and ethylene-propylene copolymers; and polyethers which are polymers of lower alkylene oxides, such as polethylene oxide.

It is preferred to keep the molecular weight of the acid containing binder-polymer to a value no greater than 50,000, preferably not greater than 25,000, and more preferably no greater than 15,000.

If the composition is to be applied by screen printing the Tg of the binder polymer preferably is above 100°C. After being screen printed the paste is usually dried at temperatures up to 100°C and a T_{g} below this value generally results in a very tacky composition. A lower T_{g} value can be employed for a material applied by other than screen printing.

The organic polymeric binder is generally present in an amount of 5-45 percent by weight based on the total weight of the dry photopolymerizable layer.

### D. Photoinitiation System

Suitable photoinitiation systems are those which are thermally inactive but which generate free radicals upon exposure to actinic light at or below 185°C. These include the substituted or unsubstituted polynuclear quinones which are compounds having two intracyclic carbon atoms in a conjugated carbocyclic ring system, e.g., 9, 10-anthraquinone, 2-methylanthraquinone, 2-ethylanthraquinone, 2-tertbutylanthraquinone, octamethylanthraquinone, 1, 4-naphthoquinone, 9, 10-phenanthrenequinone, benz(a)anthracene-7, 12-dione, 2, 3-naphthacene-5, 12-dione, 2-methyl-1, 4-naphthoquinone, 1, 4-dimethylanthraquinone, 2, 3-dimethylanthraquinone, 2-phenylanthraquinone, 2, 3-diphenylanthraquinone, retenequinone, 7, 8, 9, 10-tetrahydronaphthacene-5, 12-dione, and 1, 2, 3, 4-tetrahydrobenz(a)anthracene-7, 12-dione. Other photoinitiators which are also useful, even though some may be thermally active at temperatures as low as 85°C are described in U.S. Pat. No. 2,760,863 and include vicinal ketaldonyl alcohols such as benzoin, pivaloin, acyloin ethers, e.g., benzoin methyl and ethyl ethers; α-hydrocarbon-substituted aromatic acyloins, including α-methylbenzoin, α-allylbenzoin, and α-phenylbenzoin. Photoreducible dyes and reducing agents disclosed in U.S. Pat. Nos. 2,850,445, 2,875,047, 3,097,096, 3,074,974, 3,097,097, and 3,145,104, as well as dyes of the phenazine, oxazine, and quinone classes, Michler's ketone, Michler's ethyl ketone, benzophenone, 2, 4, 5-triphenylimidazolyl dimers with hydrogen donors including leuco dyes and mixtures thereof as described in U.S. Pat. No. 3,427,161, 3,479,185, and 3,549,367 can be used as initiators. Also useful with photoinitiators and photoinhibitors are sensitizers disclosed in U.S. Pat. No. 4,162,162. The photoinitiators or photoinitiator system is present in an amount of 0.05 to 10% by weight based on the total weight of the dry photopolymerizable layer.

### E. Photohardenable Monomer

The photohardenable monomer component of the invention is comprised of at least one addition polymerizable ethylenically unsaturated compound having at least one polymerizable ethylenic group. Such compounds are capable of forming a high polymer by free radical initiated, chain propagating addition polymerization. The monomeric compounds are nongaseous, i.e., they have a normal boiling point above 100°C, and a plasticizing action on the organic polymeric binder.

Useful monomers are disclosed in U.S. Pat. No. 5,032,490. Preferred monomers are and include polyoxyethylated trimethylolpropane triacrylate and methacrylate, ethylated pentaerythritol triacrylate, trimethylopropanetriacrylates and methacrylates, dipentaerythritol monohydroxypentaacrylate and 1, 10-decanediol dimethylacrylate. Other preferred monomers are monohydroxypolycaprolactone monoacrylate, polyethyleneglycol diacrylate (mol. wt. approximately 200), and polyethylene glycol 400 dimethacrylate (mol. wt. approximately 400). The unsaturated monomeric component is typically present in an amount of 2-20% by weight based on the total weight of the dry photopolymerizable layer.

### H. Organic Medium

The main purpose of the organic medium is to serve as a vehicle of the dispersion of the finely divided solids of the composition in such form that it can readily be applied to a ceramic or other substrate. Thus, the organic medium must first be one in which the solids are dispersible with an adequate degree of stability. Secondly, the rheological properties of the organic medium must be such that they lend good application properties to the dispersion.

The solvent component of the organic medium, which may be a mixture of solvents, is chosen so as to obtain complete solution therein of the polymer and other organic components. The solvent should be inert (non-reactive) towards the other constituents of the paste composition. The solvent(s) should have sufficiently high volatility to enable the solvent to be evaporated from the dispersion by the application of relatively low levels of heat at atmospheric pressure, however, the solvent should not be so volatile that the paste rapidly dries on a screen, at normal room temperatures, during the printing process. The preferred solvents for use in the paste compositions should have boiling points at atmospheric pressure of less than 300°C and preferably less than 250°C. Such solvents include aliphatic alcohols, esters of such alcohols, for example, acetates and propionates; terpenes such as pine oil and alpha- or beta-terpineol, or mixtures thereof; ethylene glycol and esters thereof, such as ethylene glycol monobutyl ether and butyl cellosolve acetate; carbitol esters, such as butyl carbitol, butyl carbitol acetate and carbitol acetate and other appropriate solvents such as Texanol (2,2,4-trimethyl-1,3-pentanediol monoisobutyrate).

### Additional Components

Additional components known in the art may be present in the composition including dispersants, stabilizers, plasticizers, release agents, dispersing agents, stripping agents, antifoaming agents, and wetting agents. A general disclosure of suitable materials is presented in U.S. Pat. No. 5,032,490.

### G. Polyvinylpyrrolidone Polymers and Copolymers

It is necessary in the present invention to develop thixotropic behavior in the photosensitive thick film composition. One method of developing thixotropic behavior in these compositions is to add an additional polymeric material that can hydrogen bond with the acidic groups present on the organic polymeric binder (Section C). Vinylpyrrolidone is capable of hydrogen bonding to carboxylic acid groups, and it was found that homopolymers and copolymers of vinylpyrrolidone provide the desired thixotropic behavior in these thick compositions.

It is preferred that these polyvinylpyrrolidone polymers and copolymers contain at least 30 and preferably 50-100 wt% vinylpyrrolidone. The preferred comonomer, for the polyvinylpyrrolidone copolymers, is vinyl acetate. However, it is recognized that other comonomers may also be used, provided that they do not inhibit the necessary thixotropic behavior.

It is preferred to keep the weight average molecular weight of the polyvinylpyrrolidone homopolymers and copolymers to a value no greater than 3,000,000, preferably not greater than 500,000, and more preferably no greater than 100,000.

The amount of the polyvinylpyrrolidone polymer or copolymer added to the composition can vary depending upon a number of factors, including: the degree of thixotropy desired, the vinylpyrrolidone content of the polymer, the molecular weight of the polyvinylpyrrolidone polymer/copolymer; and the acid number and molecular weight of the acid-containing organic polymer. The polyvinylpyrrolidone polymer/copolymer is generally present in an amount of 2-40% by weight based on the amount of the acid-containing organic polymer.

It will be recognized that a single polyvinylpyrrolidone homopolymer or copolymer or a combination of homopolymers and/or copolymers, each of which satisfies the above criteria, may be used in this application.

One or more of the following properties result from the introduction of thixotropic behavior in these thick film compositions: reduced settling of metallic and other inorganic components, improved leveling, e.g., in silk screen application and improved printing speed, e.g., in silk screen application.

### Processing

The photosensitive coating compositions are conventionally applied to a substrate in the form of a paste or liquid applied such as by silk screening or spraying. Thereafter the-composition is dried and then imagewise exposed to actinic radiation to obtain areas which have been exposed to actinic radiation and areas which have not been exposed. Unexposed areas of the layer are removed in a process known as development. For aqueous development the layer will be removed in portions which are not exposed to radiation but exposed portions will be substantially unaffected during development by a liquid such as wholly aqueous solutions containing 0.8% sodium carbonate by weight within the typical development duration. Generally development takes place within 0.10 to 2 minutes. It is understood that development need not take place employing sodium carbonate.

Other processing steps which may be conventional can take place before a firing operation takes place, particularly in a substantially nonoxidizing atmosphere to volatilize organic components and sinter the inorganic binder and other sinterable components.

In the following examples all parts and percentages are by weight and degrees are in centigrade unless otherwise indicated.

### EXAMPLES

### Component Materials

### A. Inorganics

- Glass Frit 1:: (component weight %) Bi₂O₃ (82.0), PbO (11.0), B₂O₃ (3.5), SiO₂ (3.5), surface area 1.5-2.5 m²/gm.
- Glass Frit II:: (component weight %) B₂O₃ (26.7), ZnO (27.7), SiO₂ (21.6), Al₂O₃ (5.9), CaO (3.9), ZrO₂ (4.0), BaO (0.8), PbO (0.7), Na₂O (8.7), surface area 1.2-2.1 m²/gm.
- Glass Frit III:: (component weight %) Bi₂O₃ (75.1), PbO (10.9), SiO₂ (9.3), CaO (2.4), B₂O₃ (1.2), Al₂O₃ (1.1), surface area 1.0-1.8 m²/gm.
- Glass Frit IV:: (component weight %) PbO 66.0), Al₂O₃ (0.8), ZnO (6.6), B₂O₃ (11.8), SiO₂ (14.8), surface area 3.1-4.1 m²/gm.
- Glass Frit V:: (component weight %) PbO (62.1), Al₂O₃ (2.6), B₂O₃ (1.8), ZnO (2.7), SiO₂ (30.8), surface area 4.3-5.5 m²/gm.
- Glass Frit VI:: (component weight %) SiO₂ (56.7), PbO (17.3), Al₂O₃ (9.1), CaO (8.0), MgO (0.3), B₂O₃ (4.5), Na₂O (2.4), K₂O (1.7), particle size d₅₀=1.7-2.9 µm.

Gold Powder: Spherical gold; particle size, d₅₀=1.8 to 2.7 µm.
Silver Powder I: Flake silver, surface area 0.2-0.4 m²/gm.
Silver Powder II: Spherical silver; particle size, d₅₀=1.5-2.4 µm.
Copper Powder: Spherical copper; particle size, d₅₀=3.0-3.6 µm.
Cuprous Oxide I: Cu₂O, surface area 1.3-2.7 m²/gm.
Cuprous Oxide II: Cu₂O, surface area 1.3-3.2 m²/gm.
Ferric Oxide: Fe₂O₃, surface area 10.0-14.0 m²/gm.
Alumina: Al₂O₃, surface area 3.2-4.1 m²/gm.
Quartz: SiO₂, surface area 3.2-4.1 m²/gm.
Pigment: CoAl₂O₄, particles size d₅₀=1.4-1.8 µm.

### B. Polymeric Binders

- Binder I:: Copolymer of 75% methylmethacrylate and 25% methacrylic acid, Mw ∼=7000. Tg=120°C, Acid No. =164.
- Binder II:: Copolymers of 19% butylacrylate, 22% methylmethacrylate, 12% ethylacrylate, 20% methacrylic acid and 27% styrene, Mw ∼=65,000, Tg=77°C, Acid. No.=

PVP K-15: Polyvinylpyrrolidone homopolymer, Mw = 12,000.
PVP K-30: Polyvinylpyrrolidone homopolymer, Mw = 55,000.
PVP K-90: Polyvinylpyrrolidone homopolymer, Mw = 1,280,000.
PVP K-120: Polyvinylpyrrolidone homopolymer, Mw = 2,800,000.
PVP/VA S-630: Copolymer of 60% vinylpyrrolidone and 40% vinyl acetate. K-value = 30-50.
PVP/VA I-335: Copolymer of 30% vinylpyrrolidone and 70% vinyl acetate. K-value = 25-35.
PVP/VA I-735: Copolymer of 70% vinylpyrrolidone and 30% vinyl acetate. K-value = 28-36.

### C. Monomers

- Monomer I:: TEOTA 1000 - Polyoxyethylated trimethylolpropane triacrylate. Mw ∼ 1162.
- Monomer II:: TMPTA - Trimethylolpropane triacrylate.

### D. Solvents

- beta-Terpineol:: 1-methyl-1-(4-methyl-4-hydroxycyclohexyl)ethene.
- Carbitol acetate:: Di(ethylene glycol) ethyl ether acetate.
- Texanol:: 2,2,4-trimethyl-1,3-pentanediol monoisobutyrate.

### E. Photoinitiators

- BP:: Benzophenone
- EMK:: Ethyl-Michler's Ketone: 4,4'-Bis(diethylamino)benzophenone
- Irgacure 651:: 2,2-Dimethoxy-1,2-diphenylethan-1-one
- ITX:: Isopropyl thioxanthone
- EPD:: Ethyl 4-(dimethylamino)benzoate

### F. Stabilizers

- Ionol:: 2,6-di-tert-butyl-4-methylphenol.
- TAOBN:: 1,4,4-Trimethyl-2,3-diazabicyclo[3.2.2]-non-2-ene-N,N'-dioxide.

### G. Additives

- BT:: 1,2,3-Benzotriazole.
- CBT:: 1H-Benzotriazole Carboxylic Acid Malonic Acid

### Preparation of Photoactive Aqueous Processable Paste

### A. Preparation of Organic Vehicle

The solvent and acrylic polymer were mixed and heated with stirring to 100°C. Heating and stirring was continued until all the binder polymer had dissolved. The solution was then cooled to 80°C and the remaining organic components added. This mixture was then stirred at 80°C until all the solids had dissolved. The solution was passed through a 325 mesh filter screen and allowed to cool. The vehicles used had the following compositions, with concentration given in parts:

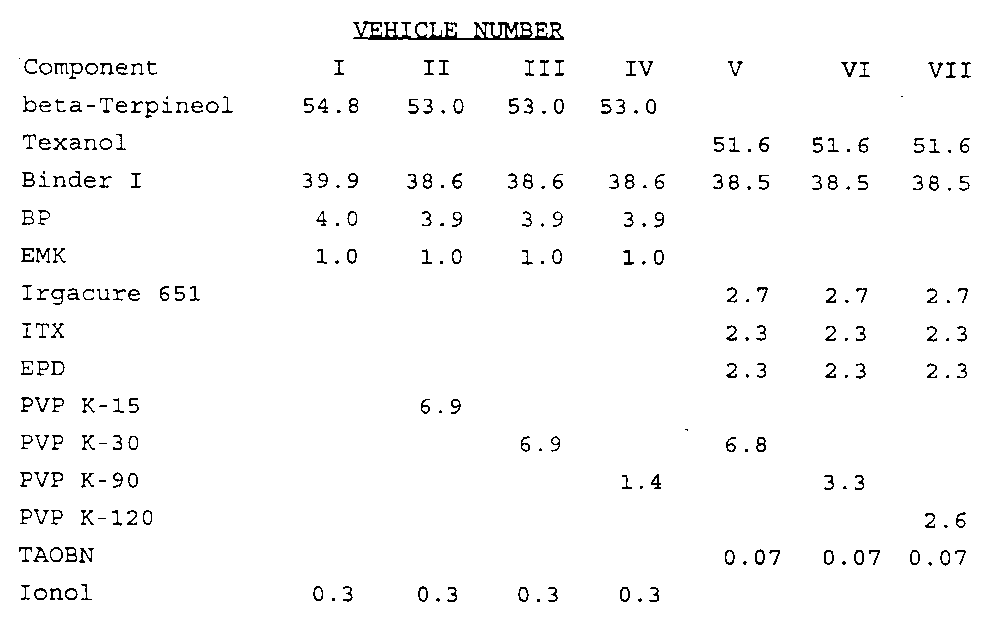

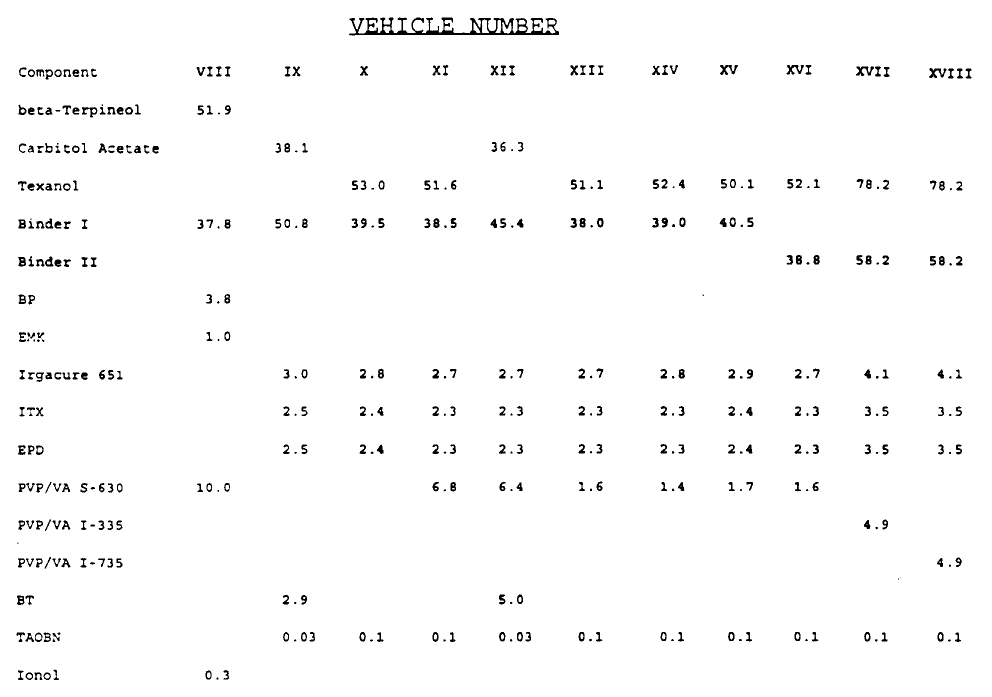

### B. Preparation of Glass Frit

The glass frit was used as available, or if necessary was prepared by water milling in a Sweco Mill using 1.27 cm (0.5 in.) diameter by 1.27 cm (0.5 in.) long alumina cylinders. The glass frit mixture was then either freeze dried or hot air dried. Hot air drying was normally done at a temperature of 150°C.

### C. Paste Formulation

The pastes were prepared under yellow light by mixing the organic vehicle, monomer or monomers, and other organic components in a mixing vessel. The inorganic materials were then added to the mixture of organic components. The total composition was then mixed until the inorganic powders were wetted by the organic materials. The mixture was then either roll milled using a three roll mill or mulled on a Hoover Automatic Muller, Model M5. The pastes were then either used directly, or screened through a 20 µm (635 mesh) screen. The paste viscosity at this point was adjusted with the appropriate vehicle or solvent to achieve a viscosity optimum for processing.

### D. Process Conditions

Care was taken to avoid dirt contamination in the process of preparing paste compositions and in preparing parts, since such contamination can lead to defects. The paste was applied to ceramic parts by screen printing using 117-38 µm (120-400 mesh) screens, depending upon the paste composition and the desired dried thickness. The parts were dried at ∼80°C in a nitrogen or air atmosphere oven. The dried coating thickness measured 12-45 microns. The parts were exposed through a phototarget with a collimated Oriel UV exposure source. The exposed parts were developed using a DuPont CII Processor containing 0.85% by weight sodium carbonate in water as the developer solution. The developer temperature was maintained at ∼30°C, and the developer solution was sprayed at 68950-103425 Pa (10-15 psi). The optimum exposure time and development rate was determined by preparing a matrix of parts with a range of exposure times and development rates for each composition. Microscopic examination of the parts after development yielded information on the best exposure time and development rate to reproducibly obtain the minimum line width or via diameter for each composition. The developed parts were dried by blowing off the excess water, after development, with a forced air stream. The dried parts were then normally fired in an air atmosphere at peak temperatures and profiles specific to the intended applications. The copper conductor sample was fired in a box furnace, using a nitrogen atmosphere, saturated with water vapor ("wet" nitrogen).

The resolution was determined from parts that reproducibly yielded the finest line spacing for which the lines were straight and non-overlapping and the smallest via diameters that were completely clean to the substrate and did not display damage to the walls or the surface of the parts. The photospeed was determined by measuring the light intensity at the surface of the dried photosensitive conductor composition with a light meter and multiplying by the time required for optimum exposure.

### EXAMPLE 1

Parts were prepared as described above, using the compositions given below with the concentration in parts. A line and space resolution of 25 µm could be achieved at a fired thickness of 15 µm, using an exposure energy of about 2300 mJ/cm². This copper conductor composition was fired on 96% alumina substrates using the "wet" nitrogen atmosphere described above. The peak temperature was 900°C.

| | Example Number |
|---|---|
| Component | 1 |
| Copper Powder | 21.2 |
| Frit I | 0.8 |
| Cuprous Oxide I | 0.8 |
| Monomer II | 0.3 |
| Monomer I | 1.0 |
| Vehicle XIII | 5.9 |
| BT | 0.04 |

### EXAMPLES 2-7

The gold conductor samples were prepared as described above, using the compositions given below, with the concentration in parts. A line and space resolution of 25 µm could be achieved at a fired thickness of 8 µm, using an exposure energy of about 850 mJ/cm². The samples were fired on 96% alumina substrates in an air atmosphere using a belt furnace with a peak temperature of 850°C. The peak temperature was maintained for 10 min.

| | Example Number | | | | | |
|---|---|---|---|---|---|---|
| Component | 2 | 3 | 4 | 5 | 6 | 7 |
| Gold Powder | 24.1 | 24.1 | 24.1 | 24.1 | 24.1 | 24.1 |
| Silver Powder I | 0.2 | 0.2 | 0.2 | 0.2 | 0.2 | 0.2 |
| Frit II | 0.4 | 0.4 | 0.4 | 0.4 | 0.4 | 0.4 |
| Cuprous Oxide II | 0.1 | 0.1 | 0.1 | 0.1 | 0.1 | 0.1 |
| Vehicle IX | | | 2.9 | 1.9 | | 1.9 |
| Vehicle X | 4.3 | 2.8 | | | 2.9 | |
| Vehicle XI | | 1.5 | | | | |
| Vehicle XII | | | 1.0 | | | |
| Vehicle V | | | | 1.9 | 1.0 | |
| Vehicle VI | | | | | | 1.9 |
| Monomer I | 1.0 | 1.0 | 1.0 | 1.0 | 1.0 | 1.0 |
| Monomer II | 0.2 | 0.2 | 0.2 | 0.2 | 0.2 | 0.2 |
| BT | 0.1 | 0.1 | | | | |

| Performance of Examples 2-7 | | | | | | |
|---|---|---|---|---|---|---|
| Example No. | Viscosity Pa.S | | | Viscosity Ratio | Printing Speed cm/s (inches/sec.) | Uniformity |
| | 0.5 RPM | 10 RPM | 50 RPM | 0.5/50 RPM | | |
| 2 | 40 | 51 | 78.6 | 0.8 | 5.08 (2) | control |
| 3 | 240 | 97 | 76 | 3.2 | 10.16-11.43 (4-4.5) | improved |
| 4 | 120 | 65 | 52 | 2.3 | 10.16-11.43 (4-4.5) | improved |
| 5 | 60 | 30 | 26 | 1.7 | - | - |
| 6 | 60 | 30 | 27 | 2.2 | - | - |
| 7 | 60 | 40 | 35 | 1.7 | - | - |

The samples containing either PVP/VA copolymers (3-4) or the PVP homopolymers (5,6,7) demonstrate at least a doubling in the viscosity ratio measured at 0.5 RPM and 50 RPM, indicating thixotropic behavior. A comparison of the printing speeds of Examples 2, 3, and 4 also shows that the printing speed is more than doubled by the introduction of the PVP/VA copolymer. Observation of parts, using backlighting also demonstrates that the fired density uniformity is improved by the introduction of the PVP/VA polymer into the composition.

### EXAMPLES 8-10

The silver conductor samples were prepared as described above, using the compositions given below, with the concentration in parts. A line and space resolution of 25 µm could be achieved at a fired thickness of 10 µm, using an exposure energy of about 850 mJ/cm². The samples were fired on 96% alumina substrates in an air atmosphere using a belt furnace with a peak temperature of 850°C or 900°C. The peak temperature was maintained for 10 min.

| | Example Number | | |
|---|---|---|---|
| Component | 8 | 9 | 10 |
| Silver Powder II | 22.6 | 73.1 | 72.5 |
| Frit III | 0.1 | | |
| Frit I | | 0.2 | 0.2 |
| Ferric Oxide | 0.1 | 0.3 | 0.3 |
| Cuprous Oxide I | 0.1 | 0.3 | 0.3 |
| Vehicle XI | 1.7 | | |
| Vehicle X | 5.1 | | |
| Vehicle XII | | 21.0 | |
| Vehicle XV | | | 21.0 |
| Monomer I | 1.3 | 4.1 | 4.0 |
| Monomer II | 0.3 | 1.0 | 1.0 |
| CBT | 0.1 | 0.2 | 0.2 |

| Performance of Examples 8-10 | | | | | |
|---|---|---|---|---|---|
| Example No. | Viscosity Pa.S | | | Viscosity Ratio | Printing Uniformity (Leveling) |
| | 0.5 RPM | 10 RPM | 50 RPM | 0.5/50 RPM | |
| 11 | 60 | 63 | 61.6 | 1.0 | poor |
| 8 | 140 | 131 | 107 | 1.3 | very smooth |
| 9 | 280 | 187 | 159.4 | 1.8 | - |
| 10 | 220 | 130 | 114 | 1.9 | - |

The samples containing PVP/VA copolymer (8,9,10) demonstrate a significant increase in the viscosity ratio measured at 0.5 RPM and 50 RPM, when compared to Example 11, indicating thixotropic behavior. Visual observation of printed and dried parts, also indicates a difference in the uniformity of the surface of several of the Examples. Example 8, with the PVP/VA addition is much more smooth than is Example 11, with no PVP/VA addition.

### EXAMPLES 11-18

The silver conductor samples were prepared as described above, using the compositions given below, with the concentration in parts. A line and space resolution of <=25 µm could be achieved at a fired thickness of 4-6 µm, using an exposure agency of bout 625 mJ/cm². The samples were fired on soda-lime glass substrates in an air atmosphere using a belt furnace with a peak temperature of 600°C. The peak temperature was maintained for 14 min.

| | Example Number | | | | | | | |
|---|---|---|---|---|---|---|---|---|
| Component | 11 | 12 | 13 | 14 | 15 | 16 | 17 | 18 |
| Silver Powder II | 21.8 | 21.3 | 21.6 | 21.3 | 21.3 | 21.2 | 21.3 | 21.3 |
| Frit I | 0.5 | 0.5 | 0.5 | 0.5 | 0.5 | 0.5 | 0.5 | 0.5 |
| Vehicle X | 6.0 | | 3.4 | 5.1 | 5.9 | | | |
| Vehicle XI | | 6.8 | 3.4 | 1.7 | 0.9 | | | |
| Vehicle XVI | | | | | | 6.8 | | |
| Vehicle XVII | | | | | | | 8.3 | |
| Vehicle XVIII | | | | | | | | 8.3 |
| Texanol | | | | | | | 1.5 | 1.5 |
| Monomer I | 1.2 | 1.2 | 1.2 | 1.2 | 1.2 | 1.2 | 1.2 | 1.2 |
| Monomer II | 0.3 | 0.3 | 0.3 | 0.3 | 0.3 | 0.3 | 0.3 | 0.3 |
| CBT | 0.1 | 0.1 | 0.1 | 0.1 | 0.1 | 0.1 | | |
| Malonic Acid | | | | | | | 0.1 | 0.1 |

| Performance of Examples 11-18 | | | | | |
|---|---|---|---|---|---|
| Example No. | Viscosity Pa.S | | | Viscosity Ratio | Printing Uniformity (Leveling) |
| | 0.5 RPM | 10 RPM | 50 RPM | 0.5/50 RPM | |
| 11 | 60 | 63 | 61.6 | 1.0 | poor |
| 12 | 2760 | 132 | 44 | 63 | - |
| 13 | 1340 | 201 | 118.4 | 11.3 | - |
| 14 | 300 | 154 | 122.4 | 2.5 | very smooth |
| 15 | 80 | 106 | 97.4 | 0.8 | moderately smooth |
| 16 | 1720 | 875 | off scale | - | - |
| 17 | 60 | 27 | 24.4 | 2.5 | - |
| 18 | 60 | 31 | 27.4 | 2.2 | - |

Examples 12-14 and 17-18, containing the PVP/VA copolymers, demonstrate a significant increase in the viscosity ratio measured at 0.5 RPM and 50 RPM versus Example 11, indicating thixotropic behavior. Example 15 shows an unusually low viscosity at 0.5 RPM, when compared to the viscosity at 10 RPM. The low level of PVP/VA in this sample may be below the value necessary to impart a significant amount of thixotropic behavior to the sample. Visual observation of printed and dried parts, also indicates a difference in the uniformity of the surface of several of the Examples. Examples 14, with the largest PVP/VA addition is more smooth than is Example 15 with lower PVP/VA addition and Example 11, is the least smooth, with no PVP/VA addition. Examples 17 and 18 demonstrated printing speeds of up to 19.05 cm/s (7.5 inches/sec).

### EXAMPLES 19-25

The silver conductor samples were prepared as described above, using the compositions given below, with the concentration in parts. A line and space resolution of <=25 µm could be achieved at a fired thickness of 4-6 µm, using an exposure energy of about 625 mJ/cm². The samples were fired on soda-lime glass substrates in an air atmosphere using a belt furnace with a peak temperature of 600°C. The peak temperature was maintained for 14 min.

| | Example Number | | | | | | |
|---|---|---|---|---|---|---|---|
| Component | 19 | 20 | 21 | 22 | 23 | 24 | 25 |
| Silver Powder II | 21.6 | 21.6 | 21.6 | 21.6 | 21.6 | 21.6 | 21.6 |
| Frit I | 0.5 | 0.5 | 0.5 | 0.5 | 0.5 | 0.5 | 0.5 |
| Vehicle XIII | 6.8 | 3.4 | 5.1 | 3.4 | 5.1 | 3.4 | 5.1 |
| Vehicle V | | 3.4 | 1.7 | | | | |
| Vehicle VI | | | | 3.4 | 1.7 | | |
| Vehicle VII | | | | | | 3.4 | 1.7 |
| Monomer I | 1.2 | 1.2 | 1.2 | 1.2 | 1.2 | 1.2 | 1.2 |
| Monomer II | 0.3 | 0.3 | 0.3 | 0.3 | 0.3 | 0.3 | 0.3 |
| CBT | 0.1 | 0.1 | 0.1 | 0.1 | 0.1 | 0.1 | 0.1 |

| Performance of Examples 19-25 | | | | |
|---|---|---|---|---|
| Example No. | Viscosity Pa.S | | | Viscosity Ratio |
| | 0.5 RPM | 10 RPM | 50 RPM | 0.5/50 RPM |
| 19 | 260 | 161 | 129.2 | 2.0 |
| 20 | 3440 | 288 | 133 | 25.9 |
| 21 | 440 | 150 | 98.4 | 4.5 |
| 22 | 180 | 121 | 108 | 1.7 |
| 23 | 220 | 148 | 124 | 1.8 |
| 24 | 200 | 130 | 113 | 1.8 |
| 25 | 200 | 138 | 118 | 1.7 |

Examples 19-25, containing the PVP/VA copolymers, demonstrate a significant increase in the viscosity ratio measured at 0.5 RPM and 50 RPM versus Example 11, indicating significant thixotropic behavior.

### EXAMPLES 26-27

The dielectric samples were prepared as described above, using the composition given below, with the concentration in parts. A via resolution of <=100 µm could be achieved at a fired thickness of 15-18 µm, using an exposure energy of about 95 mJ/cm². The samples were fired on soda-lime glass substrates in an air atmosphere using a belt furnace with a peak temperature of 540°C or 600°C. The peak temperature was maintained for 14 min.

| | Example Number | |
|---|---|---|
| Component | 26 | 27 |
| Frit IV | 7.2 | 7.2 |
| Frit V | 17.4 | 17.4 |
| Alumina | 7.4 | 7.4 |
| Vehicle I | 8.1 | 12.1 |
| Vehicle II | 8.1 | 4.0 |
| Monomer I | 4.2 | 4.2 |
| Monomer II | 1.1 | 1.1 |

| Performance of Examples 26-27 | | | | |
|---|---|---|---|---|
| Example No. | Viscosity Pa.S | | | Viscosity Ratio |
| | 1.0 RPM | 10 RPM | 100 RPM | 1.0/10 RPM |
| 26 | 430 | 300 | off scale | 1.4 |
| 27 | 300 | 175 | off scale | 1.7 |

Examples 26-27, containing the PVP/VA copolymers, demonstrate a viscosity ratio, measured at 1.0 RPM and 10 RPM, significantly above 1.0, indicating thixotropic behavior.

### EXAMPLES 28-37

The dielectric samples were prepared as described above, using the compositions given below, with the concentration in parts. A via resolution of <=75 µm could be achieved at a fired thickness of 20-25 µm, using an exposure energy of about 40 mJ/cm². The samples were fired on 96% alumina substrates in an air atmosphere using a belt furnace with a peak temperature of 850°C. The peak temperature was maintained for 10 min.

| | Example Number | | | | | | | | | |
|---|---|---|---|---|---|---|---|---|---|---|
| Component | 28 | 29 | 30 | 31 | 32 | 33 | 34 | 35 | 36 | 37 |
| Frit VI | 30.0 | 30.0 | 30.0 | 30.0 | 15.0 | 15.0 | 15.0 | 15.0 | 15.0 | 15.0 |
| Alumina | 19.2 | 19.2 | 19.2 | 19.2 | 9.6 | 9.6 | 9.6 | 9.6 | 9.6 | 9.6 |
| Quartz | 3.8 | 3.8 | 3.8 | 3.8 | 1.9 | 1.9 | 1.9 | 1.9 | 1.9 | 1.9 |
| Pigment | 1.1 | 1.1 | 1.1 | 1.1 | 0.5 | 0.5 | 0.5 | 0.5 | 0.5 | 0.5 |
| Vehicle I | 32.2 | | 15.3 | 23.0 | 8.1 | 12.1 | 8.1 | 12.1 | 8.1 | 12.1 |
| Vehicle VIII | | 33.8 | 16.9 | 8.5 | | | | | | |
| Vehicle II | | | | | 8.1 | 4.0 | | | | |
| Vehicle III | | | | | | | 8.1 | 4.0 | | |
| Vehicle IV | | | | | | | | | 8.1 | 4.0 |
| Monomer I | 8.3 | 8.3 | 8.3 | 8.3 | 4.2 | 4.2 | 4.2 | 4.2 | 4.2 | 4.2 |
| Monomer II | 2.1 | 2.1 | 2.1 | 2.1 | 1.1 | 1.1 | 1.1 | 1.1 | 1.1 | 1.1 |
| beta-Terpineol | | 6.0 | 6.0 | | | | | 1.8 | | |

| Performance of Examples 28-37 | | | | | |
|---|---|---|---|---|---|
| Example No. | Viscosity Pa.S | | | Viscosity Ratio | Printing Speed cm/s (inches/sec.) |
| | 1.0 RPM | 10 RPM | 100 RPM | 1/100 RPM | |
| 28 | 40 | 52 | 41.7 | 1.0 | (≤2) ≤5.08 |
| 29 | 80 | 84 | 69 | 1.2 | (≤3) ≤7.62 |
| 30 | 80 | 64 | 51.5 | 1.6 | (≤4.4) ≤11.18 |
| 31 | 190 | 149 | off scale | 1.3* | (≤2) ≤5.08 |
| 32 | 320 | 230 | off scale | 1.4* | (≤2) ≤5.08 |
| 33 | 190 | 154 | off scale | 1.2* | (≤4) ≤10.16 |
| 34 | 280 | 210 | off scale | 1.3* | (≤4) ≤10.16 |
| 35 | 220 | 290 | 85 | 2.6 | (≤8) ≤20.32 |
| 36 | 170 | 140 | off scale | 1.2* | (≤5) ≤12.7 |
| 37 | 150 | 130 | off scale | 1.2* | (≤6) ≤15.24 |

| | | | | | |
|---|---|---|---|---|---|
| * represents viscosity ratio of (1 RPM/10 RPM), as 100 RPM number was off scale on the viscometer used. | | | | | |

Examples 29-31, containing the PVP/VA copolymers, demonstrate a viscosity ratio, measured at 1 RPM and 100 RPM, significantly above Example 28 (Viscosity ratio ∼=1.0) indicating thixotropic behavior. Examples 29 and 30 also display faster printing speeds that does Example 28, the Example with no added PVP/VA copolymer. Example 31 displays a printing speed equivalent to that of Example 28. This may be due in part to the relatively higher viscosity of the sample at 10 RPM. An off scale reading at a 100 RPM spindle speed indicates a viscosity at that speed in excess of 100 Pa.S.

Examples 32-37, containing PVP homopolymers, also demonstrate viscosity ratios significantly above that of Example 28, indicating significant amounts of thixotropic behavior. These samples demonstrate printing speeds equivalent (Example 32, high viscosity) or generally 2-4 times faster than Example 28.

## Claims

1. An aqueous developable electrically conductive or insulating composition which is fireable in an oxidizing or substantially nonoxidizing atmosphere comprising an admixture of:
(a) finely divided particles of electrically conducting or dielectric solids having a surface area-to-weight ratio of no greater than 20 m²/g and at least 80 percent by weight of the articles having a size of 0.5-10 µm and
(b) finely divided particles of an inorganic binder having a glass transition temperature in the range of from 325° to 875°C, a surface area-to-weight ratio of no greater than than 10 m²/g and at least 90 wt. % of the particles having a size of 0.4-10 µm, the weight ratio of (b) to (a) being in a range from 0.0001 to 0.25, dispersed in an organic vehicle comprising
(c) an organic polymeric binder of a copolymer or interpolymer comprising (1) a non-acidic comonomer of a C₁-C₁₀ alkyl acrylate or C₁-C₁₀ alkyl methacrylate and (2) an ethylenically unsaturated carboxylic acid, with the proviso that all acidic comonomers comprise at least 15 weight percent of the polymer, wherein the organic polymeric binder has a molecular weight no greater than 50,000,
(d) a photoinitiation system,
(e) photohardenable monomer,
(f) an organic medium, and wherein the composition upon imagewise exposure to actinic radiation is developable in an aqueous solution containing 0.8 percent by weight sodium carbonate, wherein the improvement comprises the composition containing
(g) a homopolymer or copolymer of vinylpyrrolidone.

2. The composition of claim 1 wherein which is electrically conductive wherein (a) comprises copper, gold or silver particles.

3. The composition of claim 1 which is insulating wherein (a) comprises glass frit.

4. The composition of claim 1 wherein (g) is a homopolymer of vinylpyrrolidone.

5. The composition of claim 1 wherein (g) is a copolymer of polyvinylpyrrolidone.

6. The composition of claim 6 wherein the copolymer is formed from a comonomer of vinyl acetate.

## Patentansprüche

1. In wäßrigem Medium entwickelbare elektrisch leitfähige oder isolierende Zusammensetzung, die in einer oxidierenden oder im wesentlichen nichtoxidierenden Atmosphäre gebrannt werden kann, umfassend eine Mischung aus:
(a) feinzerteilten Partikeln aus elektrisch leitfähigen oder dielektrischen Feststoffen mit einem Verhältnis von Oberfläche zu Gewicht von nicht mehr als 20 m²/g, und wobei mindestens 80 Gew.-% der Partikel eine Größe von 0,5 - 10 µm aufweisen und
(b) feinzerteilten Partikeln aus anorganischem Bindemittel mit einer Glasübergangstemperatur im Bereich von 325° bis 875°C, einem Verhältnis von Oberfläche zu Gewicht von nicht mehr als 10 m²/g, und wobei mindestens 90 Gew.-% der Partikel eine Größe von 0,4 - 10 µm aufweisen, wobei das Gewichtsverhältnis von (b) zu (a) im Bereich von 0,0001 bis 0,25 liegt, dispergiert in einem organischen Trägermaterial, welches umfaßt
(c) einem organischen polymeren Bindemittel aus einem Copolymer oder Mischpolymerisat, umfassend (1) ein nicht-saures Comonomer eines C₁- bis C₁₀-Alkylacrylats oder C₁- bis C₁₀-Alkylmethacrylats und (2) eine ethylenisch ungesättigte Carbonsäure, mit der Maßgabe, daß alle sauren Comonomere mindestens 15 Gew.-% des Polymers umfassen, wobei das polymere Bindemittel ein Molekulargewicht von nicht mehr als 50000 aufweist,
(d) einem Photoinitiationssystem,
(e) einem lichthärtbaren Monomer,
(f) einem organischen Medium, und wobei die Zusammensetzung nach bildweiser Belichtung mit aktinischer Strahlung in einer wäßrigen Lösung, die 0,8 Gew.-% Natriumcarbonat enthält, entwickelbar ist, wobei die Verbesserung die Zusammensetzung umfaßt, die
(g) ein Homopolymer oder Copolymer von Vinylpyrrolidon enthält.

2. Zusammensetzung nach Anspruch 1, die elektrisch leitfähig ist, wobei (a) Kupfer, Gold oder Silberpartikel umfaßt.

3. Zusammensetzung nach Anspruch 1, die isolierend ist, wobei (a) Glasfritte umfaßt.

4. Zusammensetzung nach Anspruch 1, wobei (g) ein Homopolymer von Vinylpyrrolidon ist.

5. Zusammensetzung nach Anspruch 1, wobei (g) ein Copolymer von Polyvinylpyrrolidon ist.

6. Zusammensetzung nach Anspruch 6, wobei das Copolymer aus einem Comonomer von Vinylacetat gebildet wird.

## Revendications

1. Composition aqueuse développable conductrice ou isolante de l'électricité qui peut être cuite dans une atmosphère oxydante ou pratiquement non oxydante comprenant un mélange additionnel :
(a) de particules finement divisées de solides conducteurs de l'électricité ou diélectriques ayant un rapport d'aire de surface sur poids de pas plus de 20 m²/g et au moins 80 pour-cent en poids des articles ayant une dimension de 0,5-10 µm et
(b) de particules finement divisées d'un liant inorganique ayant une température de transition vitreuse dans l'intervalle de 325°C à 875°C, un rapport d'aire de surface sur poids de pas plus de 10 m²/g et au moins 90% en poids des particules ayant une dimension de 0,4-10 µm, le rapport en poids de (b) à (a) étant dans un intervalle de 0,0001 à 0,25, dispersées dans un véhicule organique comprenant
(c) un liant polymère organique d'un copolymère ou d'un interpolymère comprenant (1) un comonomère non acide d'un (alkyle en C₁-C₁₀)acrylate ou d'un (alkyle en C₁-C₁₀)méthacrylate et (2) un acide carboxylique éthyléniquement insaturé, à condition que tous les comonomères acides comprennent au moins 15 pour-cent en poids du polymère, dans lequel le liant polymère organique a un poids moléculaire de pas plus de 50 000,
(d) un système de photoinitiation,
(e) un monomère photodurcissable,
(f) un milieu organique, et dans lequel la composition lors d'une exposition selon une image à un rayonnement actinique est développable dans une solution aqueuse contenant 0,8 pour-cent en poids de carbonate de sodium, dans laquelle l'amélioration comprend la composition contenant
(g) un homopolymère ou un copolymère de vinylpyrrolidone.

2. Composition suivant la revendication 1, qui est conductrice de l'électricité dans laquelle (a) comprend des particules de cuivre, d'or ou d'argent.

3. Composition suivant la revendication 1, qui est isolante, dans laquelle (a) comprend une fritte de verre.

4. Composition suivant la revendication 1, dans laquelle (g) est un comopolymère de polyvinylpyrrolidone.

5. Composition suivant la revendication 1, dans laquelle (g) est un copolymère de vinylpyrrolidone.

6. Composition suivant la revendication 6, dans laquelle le copolymère est formé d'un comonomère d'acétate de vinyle.
